# EUROPÄISCHE PATENTSCHRIFT

(11) **EP 2 856 095 B1**
(45) Veröffentlichungstag und Bekanntmachung des Hinweises auf die Patenterteilung: **08.08.2018**
(21) Anmeldenummer: 13717248.2
(22) Anmeldetag: 12.04.2013
(51) Int. Cl.: G01J 5/20, H01L 31/103, H01L 31/0352, H01L 27/146, G01J 5/02, G01J 5/04

(54) **INFRAROT-SENSORVORRICHTUNG UND VERFAHREN ZUR HERSTELLUNG EINER INFRAROT-SENSORVORRICHTUNG**
INFRARED SENSOR DEVICE AND METHOD FOR PRODUCING AN INFRARED SENSOR DEVICE
DISPOSITIF DE DÉTECTION INFRAROUGE ET SON PROCÉDÉ DE PRODUCTION

(30) Priorität: 16.05.2012 DE 102012208192
(43) Veröffentlichungstag der Anmeldung: 08.04.2015
(73) Patentinhaber: Robert Bosch GmbH, 70442 Stuttgart (DE)
(72) Erfinder: HERRMANN, Ingo, 71292 Friolzheim (DE); SCHELLING, Christoph, 70597 Stuttgart (DE)
(86) Internationale Anmeldenummer: PCT/EP2013/057693
(87) Internationale Veröffentlichungsnummer: WO 2013/171010

(56) Entgegenhaltungen:
- DE-A1-102007 008 381
- JP-A- 2005 009 998
- US-A1- 2001 028 035
- US-A1- 2007 152 265

## Beschreibung

Die vorliegende Erfindung betrifft eine Infrarot-Sensorvorrichtung und ein Verfahren zur Herstellung einer Infrarot-Sensorvorrichtung.
Die US 2001/0028035 A1 offenbart eine Infrarot-Sensorvorrichtung, wobei ein Sensorelement mit Dioden mittels einer Aufhängeeinrichtung in einem Wafersubstrat aufgehängt ist, wobei das Sensorelement im Wesentlichen unterhalb der Aufhängeeinrichtung angeordnet ist.
Die JP 2005 009998 A offenbart eine Infrarot-Sensorvorrichtung, wobei ein Sensorelement mit Dioden, welche U-förmige Siliziumbereiche aufweisen, über eine Aufhängeeineichtung in einem Wafersubstrat aufgehängt ist.

Im Stand der Technik sind oberflächenmikromechanisch hergestellte Pixelstrukturen bekannt. Beispielsweise offenbart die WO 9325877 in Passivierschichten aus SiO₂ oder SiₓNₓ eingebettete dünne Metallleitungen mit einem ebenfalls in Passivierschichten eingebetteten Bolometerschichtwiderstand, welche in einer Anordnung verbunden sind, die zusammen mit einer Reflexionsschicht in geeignetem Abstand einen λ/4-Absorber bildet.

Aus der WO 2007147663 ist die bulkmikromechanische Herstellung von thermisch isolierenden Kavernen bekannt, über denen dann durch Strukturierung der Si- oder SOI-Membran an möglichst langen und dünnen Armen aufgehängte Sensorelemente erzeugt werden.

Ferner ist ein IR-Sensorarray basierend auf einer SOI-Pixeltechnologie mit Rundumpassivierung bekannt. Die Aufhängeärmchen sind bei diesem IR-Sensorarray zwischen Pixel und Spalten- bzw. Zeilenverdrahtung angeordnet. Der pn-Übergang erstreckt sich bis zur Oberfläche.

### Offenbarung der Erfindung

Aufgabe der Erfindung ist es, eine verbesserte Infrarot-Sensorvorrichtung bereitzustellen, die es erlaubt, auf derselben Fläche mehr Pixel unterzubringen.

Die Aufgabe wird gelöst mit einer Infrarot-Sensorvorrichtung, nach Anspruch 1.

Die vorliegende Erfindung schafft gemäß einem weiteren Aspekt ein Infrarot-Sensorfeld mit mehreren erfindungsgemäßen Infrarot-Sensorvorrichtungen.

Gemäß einem weiteren Aspekt wird mit der Erfindung ein Verfahren zur Herstellung einer Infrarot-Sensorvorrichtung bereitgestellt, welches in Anspruch 11 definiert ist.

### Vorteile der Erfindung

Vorteilhaft wird durch die Anordnung des Sensorelements unterhalb der Aufhängeinrichtung eine Infrarot-Sensorvorrichtung mit Pixeln, die einen höheren Flächenfüllfaktor besitzen bereitgestellt. Dadurch können bei einer Verwendung der Infrarot-Sensorvorrichtung in einer Thermographie-Kamera eine Pixeldichte erhöht sein.

Bevorzugte Weiterbildungen sind Gegenstand der jeweiligen Unteransprüche.

Durch Ausbildung von Dioden wird vorteilhaft ein Sensorelement bereitgestellt, welches eine ihren Wert temperaturabhängig ändernde Eigenschaft aufweist. Für die Erfindung wird somit die durch die Infrarotstrahlung bewirkte Temperaturänderung ausgenützt, um einen durch die Temperaturänderung veränderten Spannungsabfall an den Dioden auszuwerten.

Erfindungsgemäß ist die Infrarot-Sensorvorrichtung dadurch gekennzeichnet, dass das Halbleitersubstrat des Sensorelements einkristalline, im wesentlichen U-förmige Siliziumbereiche aufweist, wobei Dotierungsgebiete der Siliziumbereiche im Wesentlichen vertikal angeordnet sind. Durch die vertikale Anordnung der Dotierungsgebiete wird der temperaturempfindliche Bereich des Sensorelements in die Tiefe verlagert, wodurch die geringere Defektdichte in der Raumladungszone des pn-Übergangs der Diode genutzt wird entsteht. Dadurch fließen vorteilhaft geringere Oberflächenleckströme. Die Flächenausmaße des Sensorelements können dadurch zudem vorteilhaft reduziert sein, woraus eine kompakte Bauart des Sensorelements resultiert.

Erfindungsgemäß ist die Infrarot-Sensorvorrichtung dadurch gekennzeichnet, dass die Dotierungsgebiete durch Oxidmaterial lateral voneinander getrennt sind. Dadurch steht vorteilhaft ein zusätzliches Absorbervolumen für die zu detektierende IR-Strahlung zur Verfügung.

Eine vorteilhafte Weiterbildung der Infrarot-Sensorvorrichtung sieht vor, dass mittels der Aufhängeeinrichtung das Sensorelement in zwei Bereichen mit dem übrigen (SOI-)Wafer verbunden ist. Dadurch entsteht bei einer Verwendung in einem Sensorarray einerseits eine geringe thermische Kopplung der einzelnen Sensorelemente untereinander und zum Substrat hin.

Eine bevorzugte Ausführungsform der erfindungsgemäßen Infrarot-Sensorvorrichtung ist dadurch gekennzeichnet, dass die Aufhängeeinrichtung in vertikaler Richtung symmetrisch ausgebildet ist, wobei eine elektrische Leiterbahn in der Aufhängeeinrichtung im Wesentlichen mittig zwischen zwei im Wesentlichen gleich dicken Schichten von Oxidmaterial angeordnet ist. Vorteilhaft ergibt sich dadurch ein stresssymmetrischer Aufbau der Aufhängestruktur, was eine verringerte Grundauslenkung nach einem Freiätzen der Aufhängeeinrichtung und einen Gang der Auslenkung mit der Temperatur unterstützt.

Eine bevorzugte Ausführungsform der erfindungsgemäßen Infrarot-Sensorvorrichtung ist dadurch gekennzeichnet, dass die Leiterbahn im Wesentlichen im Zentrum des Sensorelements ansetzt und oberhalb des Sensorelements im Wesentlichen spiralförmig ausgebildet ist. Auf diese Weise können kreuzungsfrei sehr lange Aufhängeärmchen realisiert werden. Dadurch entsteht vorteilhaft eine geringe Wärmeableitung, was vorteilhaft eine geringe thermische Kopplung des Sensorelements an das Substrat bewirkt.
Eine bevorzugte Ausführungsform der erfindungsgemäßen Infrarot-Sensorvorrichtung sieht vor, dass ein Material der elektrischen Leiterbahnen wenigstens eines aus der Gruppe: Ti, TiN, Ta, TaN oder eine Kombination dieser Materialien ist. Mit diesen Materialien bzw. Kombinationen daraus wird ein günstiger Kompromiss zwischen elektrischer Leitfähigkeit und Wärmeleitung eingegangen, wodurch das Sensorelement vorteilhaft nur geringfügig an das Substrat gekoppelt wird.
Eine bevorzugte Ausführungsform der erfindungsgemäßen Infrarot-Sensorvorrichtung ist dadurch gekennzeichnet, dass eine optische Dicke von auf dem Sensorelement angeordneten Schichten des Oxidmaterials im wesentlichen einem ungeradzahligen Vielfachen eines Viertels einer zu detektierenden Wellenlänge entspricht. Dies stellt eine günstige Dimensionierung der Oxidschicht zur Absorption der zu detektierenden Wellenlänge dar.
Eine bevorzugte Ausführungsform der erfindungsgemäßen Infrarot-Sensorvorrichtung ist dadurch gekennzeichnet, dass eine Dicke der Schichten des Oxidmaterials oberhalb des Sensorelements größer ist als im Bereich der Aufhängeeinrichtung. Mit dem Ausdruck "oberhalb" des Sensorelements ist im Rahmen dieser Anmeldung die, in Bezug auf das Sensorelement, der Oberseite der Infrarot-Sensorvorrichtung zugewandten Seite gemeint. Dadurch wird vorteilhaft eine erhöhte Absorberschichtdicke nur im Bereich des Sensorelements, nicht jedoch im Bereich der Aufhängestruktur bereitgestellt. Dies kann vorteilhaft eine Steigerung des Signal-Rausch-Verhältnisses bewirken.
Eine vorteilhafte Weiterbildung der erfindungsgemäßen Infrarot-Sensorvorrichtung zeichnet sich dadurch aus, dass auf einer Oberfläche des Sensorelements eine Reflektorschicht angeordnet ist. Vorteilhaft werden auf diese Weise ein Absorptionsweg und damit eine Absorption der zu detektierenden Strahlung vergrößert.

Weitere Merkmale und Vorteile der vorliegenden Erfindung werden nachfolgend anhand von Ausführungsformen mit Bezug auf die Figuren erläutert. Dabei bilden alle beschriebenen oder dargestellten Merkmale für sich oder in beliebiger Kombination den Gegenstand der Erfindung, unabhängig von ihrer Zusammenfassung in den Patentansprüchen oder deren Rückbeziehung, sowie unabhängig von ihrer Formulierung bzw. Darstellung in der Beschreibung bzw. in den Figuren. Die Figuren sind vor allem dazu gedacht, die erfindungswesentlichen Prinzipien zu verdeutlichen und sind nicht notwendigerweise maßstabsgetreu. In den Figuren bezeichnen gleiche Bezugszeichen gleiche bzw. funktionsgleiche Elemente.

### Kurze Beschreibung der Zeichnungen

Es zeigen:
- Fig. 1a: eine Querschnittsansicht durch eine Ausführungsform der erfindungsgemäßen Infrarot-Sensorvorrichtung;
- Fig. 1b: eine Draufsicht auf eine Ausführungsform der erfindungsgemäßen Infrarot-Sensorvorrichtung; und
- Fig. 2a bis Fig. 2 f: Verfahrensabschnitte eines Verfahrens zur Herstellung einer Ausführungsform der erfindungsgemäßen Infrarot-Sensorvorrichtung mit entsprechenden Zwischenprodukten.

### Ausführungsformen der Erfindung

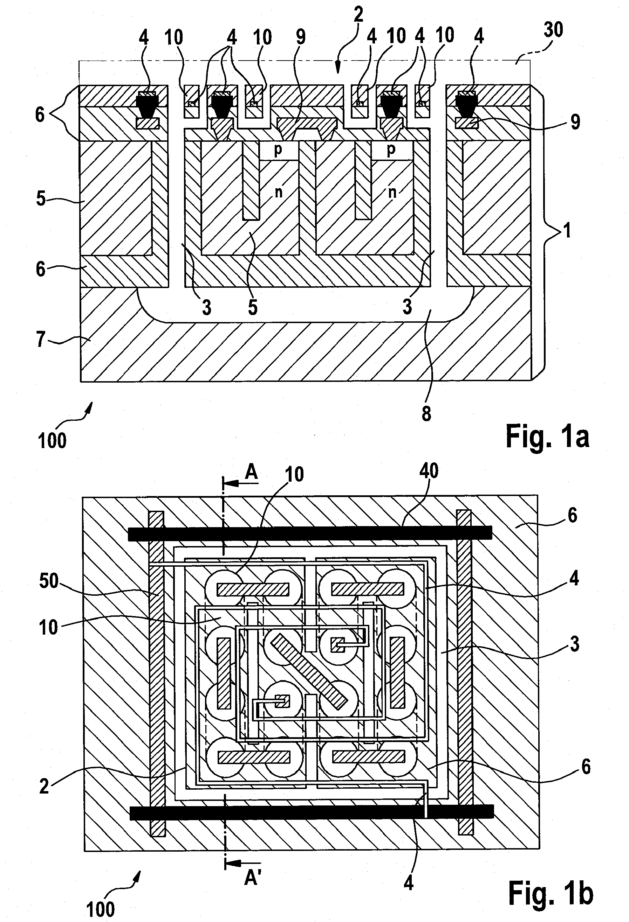

Fig. 1a zeigt eine prinzipiellen Querschnittsansicht in einer Schnittebene A-A' von Fig. 1b einer Ausführungsform der erfindungsgemäßen Infrarot-Sensorvorrichtung 100. Ein Grundmaterial der Infrarot-Sensorvorrichtung 100 umfasst einen SOI-Wafer 1 (engl. silicon-on-insulator, Silizium auf Isolator), der ein Trägersubstrat 7 (engl. handle wafer), ein Oxidmaterial 6 und eine Bauelement-Schicht mit einem Halbleitersubstrat 5 umfasst. Auf einer Oberfläche des SOI-Wafers 1, welche an einer Oberseite 11 der Infrarot-Sensorvorrichtung 100 angeordnet ist, sind mehrere Schichten von Oxidmaterial 6 aufgebracht, die eine Metallisierungsebene mit Leiterbahnen 4 zur elektrischen Versorgung eines Sensorelements 2 darstellen.

Das Sensorelement 2 ist als eine Halbleiterdiode ausgebildet, wobei als Grundmaterial der Diode vorzugsweise einkristallines Silizium verwendet wird, welches gegenüber polykristallinem Silizium vorteilhaft ein deutlich verbessertes Rauschverhalten (z.B. durch Entfall des Korngrenzenrauschens) aufweist. Das Sensorelement 2 ist innerhalb des (SOI-)Wafers 1, welches an einer Unterseite 12 der Infrarot-Sensorvorrichtung 12 der Infrarot-Sensorvorrichtung 100 angeordnet ist, durch Wärmeisolationsgräben in Form eines umlaufenden Spalts 3 und einer Kaverne 8 vom restlichen Substrat thermisch isoliert. Im Wesentlichen ist die Struktur der Diode vertikal ausgerichtet, wobei die Diode im Wesentlichen U-förmig ausgebildete, dotierte Halbleitersubstratgebiete aufweist. Dies bewirkt vorteilhaft verringerte Oberflächenleckströme durch Verlagerung des pn-Übergangs in die Tiefe und eine geringere Defektdichte in der Raumladungszone. Durch die im Wesentlichen U-förmige Grundstruktur der Diode ist zudem eine Packungsdichte der Dioden vorteilhaft erhöht, was eine höhere Pixeldichte in einer Verwendung in einem Sensorarray bewirken kann.

Eine Aufhängeeinrichtung 10 für das Sensorelement 2 wird durch rundum freigestellte Schichten von Oxidmaterial 6 gebildet, in denen Leiterbahnen 4 angeordnet sind. In vertikaler Ausrichtung ist die Aufhängeeinrichtung 10 im Wesentlichen symmetrisch aufgebaut, wobei eine Dicke des Oxidmaterials 6 im Bereich der Aufhängeeinrichtung 10 kleiner ist als im Bereich des übrigen Sensorelements 2. Dadurch kann eine Wärmeleitfähigkeit der Aufhängeeinrichtung 10 durch eine geringe Querschnittsfläche vorteilhaft niedrig gehalten werden. Im Ergebnis lässt sich dadurch ein verbessertes Signal-Rausch-Verhältnis (SNR) der Infrarot-Sensorvorrichtung 100 durch eine erhöhte Absorberschichtdicke im Pixelbereich, die im Bereich der Aufhängeeinrichtung 10 nicht vorhanden ist, erreichen. Vorteilhaft kann dadurch eine hochempfindliche Infrarot-Sensorvorrichtung 100 bereitgestellt werden.

Lateral um die Dotierungsgebiete der Diode ist ebenfalls Oxidmaterial 6 angeordnet, was vorteilhaft eine vergrößerte Absorberschichtdicke bewirkt, sowie eine definierte Abgrenzung der einzelnen Diodenelemente untereinander bereitstellt. Zudem muss dadurch ein laterales Ausdiffundieren der Dotierungsgebiete der Diode nicht berücksichtigt werden, was vorteilhaft eine höhere Integrationsdichte für das Sensorelement 2 zulässt.

Eine optische Dicke der Oxidschichten auf dem Sensorelement 2 entspricht im Wesentlichen einem ungeradzahligen Vielfachen eines Viertels der zu detektierenden Wellenlänge λ, was sich als besonders günstig für die Absorption von elektromagnetischer Strahlung herausgestellt hat. Durch den symmetrischen Aufbau der Aufhängeeinrichtung 10 ist zudem eine verringerte Grundauslenkung nach einem Freiätzen der Aufhängeeinrichtung 10 und eine geringe Temperaturabhängigkeit der Auslenkung unterstützt.

Eine Leiterbahn 4 umfasst vorzugsweise eine Einzellage oder Mehrlagen einer Kombination der folgenden Materialien: Ti, TiN, Ta, TaN. Diese Materialien weisen allesamt vorteilhaft einen günstigen Kompromiss zwischen elektrischer Leitfähigkeit und Wärmeleitung auf, so dass durch die Verwendung der genannten Materialien eine unnötige Erwärmung des Sensorelements 2 vermieden wird. Eine Leiterbahn 4 weist vorzugsweise einen Querschnitt von weniger als ungefähr 0,1 µm² auf.
Ein polykristallines Silizium 9 kann vorteilhaft für die Leiterbahnen 4 und als Opferschichtmaterial bei der Herstellung der Infrarot-Sensorvorrichtung 100 verwendet werden.

Optional ist auf einer Oberfläche an der Oberseite 11 der Infrarotsensorvorrichtung 100 eine Reflektorschicht 30 angeordnet, die eine Absorption der zu detektierenden Strahlung erhöht und dadurch einen Wirkungsgrad der Infrarot-Sensorvorrichtung 100 vorteilhaft erhöht.

Fig. 1b zeigt eine prinzipielle Draufsicht auf eine Ausführungsform einer erfindungsgemäßen Infrarot-Sensorvorrichtung 100. Erkennbar ist der um das Sensorelement 2 vollständig umlaufende Spalt 3, der das Sensorelement 2 vom übrigen Substrat thermisch isoliert. Der Spalt 3 dient zudem in einem Herstellungsprozess der Infrarot-Sensorvorrichtung 100 als ein Opferschichtätzloch. Das Sensorelement 2 weist beispielhaft insgesamt acht Dioden auf, wobei eine Mindestanzahl der Dioden für das Sensorelement 2 eins beträgt. Die Dioden sind elektrisch in Reihe und/oder parallel geschaltet, wobei in das Silizium des Halbleitersubstrats 5 jeweils ein Diodenelement derart integriert ist, dass die Dotierungsgebiete lateral durch Oxidgräben begrenzt werden. Es ist ferner erkennbar, dass die Dioden des Sensorelements 2 im Wesentlichen unterhalb der Aufhängeeinrichtung 10 angeordnet sind. Dadurch kann ein Flächenfüllfaktor des Sensorelements 2 vorteilhaft erhöht sein, wodurch auf einer definierten Fläche eine größere Anzahl von Sensorelementen 2 angeordnet werden können.

Leiterbahnen 4 setzen im Wesentlichen im Zentrum des Sensorelement 2 an und sind im Wesentlichen spiralförmig über dem Sensorelement 2 ausgebildet. Dabei wird der Spalt 3 lediglich in zwei Bereichen überbrückt, um eine elektrisch leitende Verbindung zwischen dem Sensorelement 2 und einer Zeilenleitung 40 bzw. einer Spaltenleitung 50 der Infrarot-Sensorvorrichtung 100 bereitzustellen. Die Ärmchen der Aufhängeeinrichtung 10 mit den Leiterbahnen 4 sind gegenüber herkömmlichen Konstruktionen im Wesentlichen vollständig oberhalb, d. h. der Oberseite 11 zugewandten Seite, des Sensorelements 2 ausgebildet und nicht etwa daneben wie im Stand der Technik, was vorteilhaft eine Flächenersparnis und damit einen höheren Flächenfüllfaktor bewirkt. Eine Verankerung (nicht dargestellt) der Aufhängeeinrichtung 10 mit der Leiterbahnen 4 erfolgt auf dem SOI-Wafer 1 an Angriffspunkten von geeigneten Ankerstrukturen. Beispiele für diese Strukturen sind Stützsäulen oder Wände (nicht dargestellt) zwischen den einzelnen Sensorelementen 2, wobei die Strukturen der Stützsäulen aus Halbleitersubstratmaterial gebildet sind.

Für eine Metallisierung der Zeilenleitung 40 bzw. der Spaltenleitung 50 wird beispielsweise Aluminium mit einer Silizium-Kupfer Dotierung (Al-Si-Cu) gewählt. Das genannte Material kann auch für eine Metallisierung innerhalb des Sensorelements 2 verwendet werden. Die Leiterbahnen 4 in den Armen der Aufhängeeinrichtung 10 sind in Relation zu ihrem Querschnitt lang und schmal ausgebildet, was vorteilhaft eine geringe Wärmekopplung zwischen dem Sensorelement 2 und dem Halbleitersubstrat 5 bewirkt. Wärmebrücken zwischen den einzelnen Sensorelementen 2 und zum Substrat 7 sind dadurch vorteilhaft möglichst klein ausgebildet.

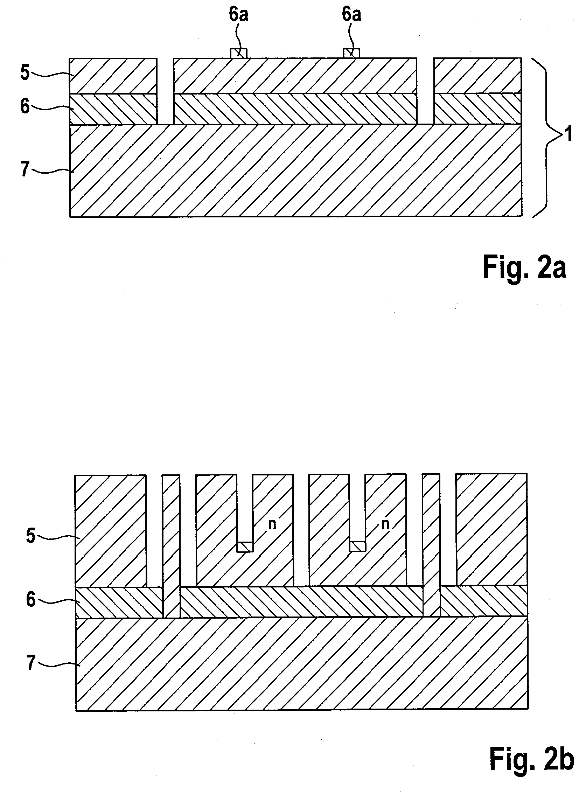

Fig. 2a zeigt ein Zwischenprodukt eines ersten Schritts zur Herstellung der erfindungsgemäßen Infrarot-Sensorvorrichtung. Es wird dabei ein (SOI-)Wafer 1 bereitgestellt, der die einzelnen Schichten Trägersubstrat 7, Oxid-Material 6 (vorzuweise ausgebildet als BOX, engl. buried oxide) und eine Schicht mit Halbleitersubstrat 5 umfasst. Das Halbleitersubstrat 5 ist vorzugsweise als ein monokristallines Silizium ausgebildet, wodurch vorteilhaft ein Korngrenzenrauschen innerhalb des Halbleitersubstrats 5 vermieden ist. Zwei Inseln mit Stoppoxid 6a werden zum Zwecke eines Trenchätzstopps aufgebracht. Ferner werden in den SOI-Wafer 1 von oben Gräben eingeätzt, um den (SOI-)Wafer 1 bis auf die Unterseite der vergrabenen Oxidschicht zu strukturieren.

Fig. 2b zeigt ein Zwischenprodukt eines nächstfolgenden Epitaxie-Schritts, bei dem ein Material des Halbleitersubstrats 5 auf die Struktur von Fig. 2a aufgewachsen wird. Sowohl die Epitaxieschicht als auch das zuvor bereits vorhandene Material ist dabei vorteilhaft bereits dotiert. Ferner werden Gräben eingeätzt, um eine grundlegende geometrische Struktur der erfindungsgemäßen Sensorvorrichtung 100 bereitzustellen. Erkennbar ist, dass die Grundstruktur des Sensorelements 2 innerhalb des Halbleitersubstrats 5 im Wesentlichen U-förmig ausgebildet ist.

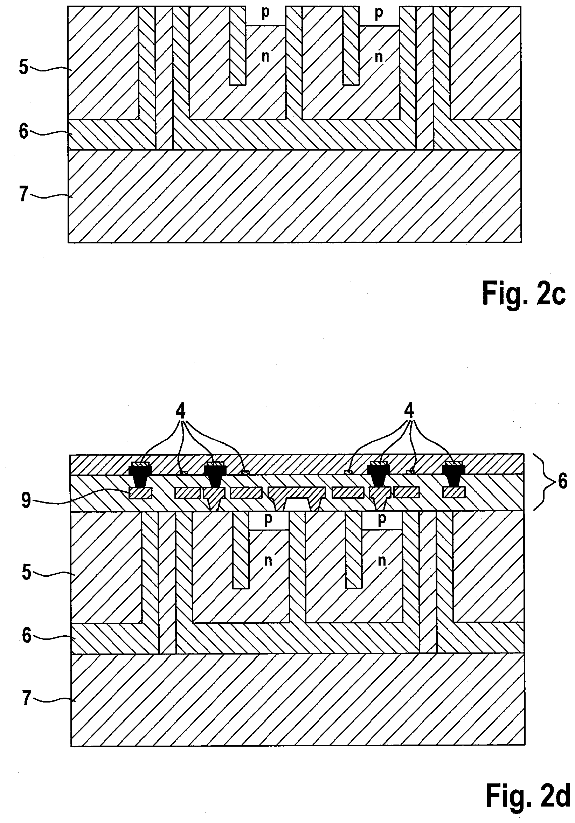

Fig. 2c zeigt ein weiteres Zwischenprodukt eines nächstfolgenden Schritts, bei dem in die bestehenden Trenchgräben Oxidmaterial 6 verfüllt wird. Das in die Trenchgräben verfüllte Oxidmaterial 6 wirkt vorteilhaft als zusätzliches Absorbervolumen für die zu detektierende Strahlung. Ferner wird in diesem Schritt eine p-Dotierung in Teilbereichen des Halbleitersubstrats 5 durchgeführt.

Fig. 2d zeigt prinzipiell, dass in einem nächstfolgenden Schritt mehrere Schichten von Oxidmaterial 6 auf die aus Fig. 2c erhaltene Struktur aufgebracht werden. Dabei werden innerhalb der Schichten mindestens zwei Verdrahtungsebenen abgeschieden und strukturiert. Auf diese Weise werden Leiterbahnen 4 erhalten, welche vorzugsweise drei unterschiedliche Materialien aufweisen können. Diese umfassen eines oder mehrere aus der Materialien: Ti, TiN, Ta, TaN oder eine Kombination dieser Materialien. Ferner (dargestellt in Schwarz) umfassen die Materialien z.B. Aluminium mit einer Silizium-Kupfer-Dotierung, wobei dieses Material insbesondere für die Zeilenleitung 40 und Spaltenleitung 50 verwendet wird. Schließlich können die Materialien polykristallines Silizium 9 umfassen.

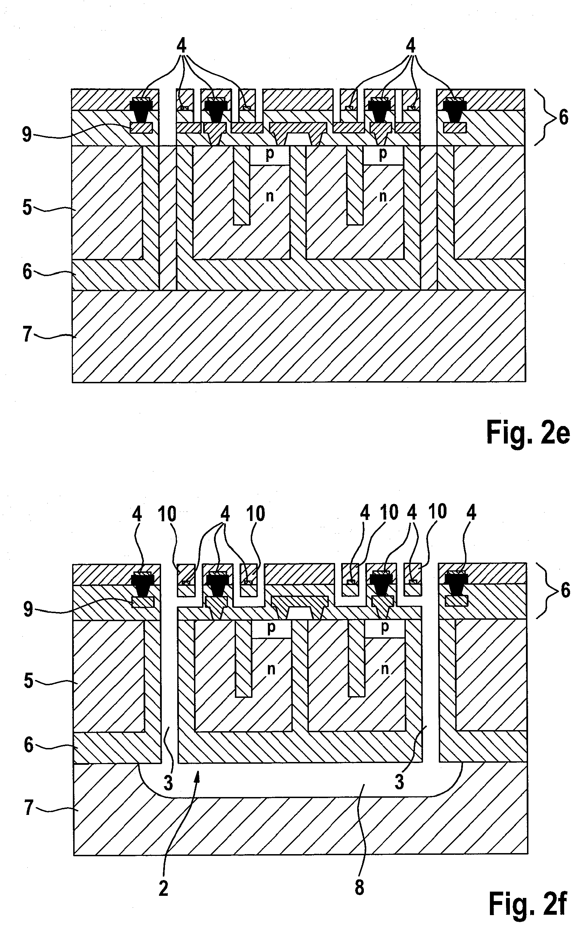

Fig. 2e zeigt ein Zwischenprodukt eines nächstfolgenden Schritts bei dem Opferschichtätzlöcher in die Struktur von Fig. 2d eingebracht wurden.

Fig. 2f zeigt ein Ergebnis eines letzten Schritts des Herstellungsverfahrens der erfindungsgemäßen Infrarot-Sensorvorrichtung 100. Dabei wird ein Opferschichtätzen durchgeführt, wodurch ein räumlich im Wesentlichen freigestelltes Sensorelement 2 gebildet wird, welches durch einen Spalt 3 und eine unterhalb des Sensorelements 2 angeordnete Kaverne 8 vom umliegenden Substrat thermisch isoliert ist. Ferner erfolgt ein Unterätzen der Schichten von Oxidmaterial 6, um dadurch die Aufhängeeinrichtung 10 für das Sensorelement 2 zu bilden bzw. freizulegen. Dadurch entsteht vorteilhaft eine geringe thermische Kopplung zwischen den Sensorelement 2 und dem umliegenden Substrat.

Als zusätzlicher finaler Schritt (nicht in den Figuren dargestellt) wird bei der Fertigung eines Sensorarrays mit Bildpixeln noch ein Waferlevel-Verkappen des Arraywafers mit einem geeigneten Kappenwafer zur Erzeugung eines hinreichend guten Vakuums zur thermischen Isolierung und zum Schutz der sensierenden Diodenelemente durchgeführt.

Zusammenfassend wird mit der Erfindung eine verbesserte Infrarot-Sensorvorrichtung geschaffen, die sich für eine Verwendung in einem Sensorarray, z.B. für einen Einsatz in Thermographie-Kameras eignet. Die Erfindung kann in allen Anwendungen eingesetzt werden, in denen thermische Strahlung räumlich aufgelöst detektiert werden soll und bei denen Stückkosten eine größere Rolle spielen als hochpräzise Temperaturmessung. Beispiele hierfür sind KfZ-Nachtsichtvorrichtungen und die Thermographie, beispielsweise für die Gebäudedämmung oder die Prozessüberwachung. Ferner können mit der Erfindung Thermographiekameras für den Hausgebrauch (z.B. zur Lokalisierung von Isolations- bzw. Wärmelecks) realisiert werden. Zudem kann die erfindungsgemäße Infrarot-Sensorvorrichtung als ein Einzelpixel zur Temperaturüberwachung unter Erfassungder thermischen Eigenstrahlung verschiedener Gegenstände, Einrichtungen oder Lebewesen verwendet werden.
Vorteilhaft weist ein mit der erfindungsgemäßen Infrarot-Sensorvorrichtung realisiertes Bildpixelelement eine geringe thermische Kopplung an das Substrat durch einen geringen Querschnitt der Aufhängeeinrichtung, durch eine große Länge von Armen der Aufhängeeinrichtung, durch fehlende Wärmebrücken und durch eine dicke Absorberschicht und/oder Reflektorschicht auf.
Durch das Vorhandensein der Schichten von Oxidmaterial in lateraler Erstreckung um die Diode herum muss ein laterales Ausdiffundieren der Implantationen nicht berücksichtigt werden, wodurch die Lateralabmessungen der Diode vorteilhaft lithografisch definiert sind. Dies erlaubt vorteilhaft eine dichtere Auslegung auf kleinerer Fläche.
Des Weiteren ist der pn-Übergang der Diode von der Oberfläche des Sensorelements beabstandet, das bedeutet von Implantationsschäden der Dotierungsvorgänge des Halbleitersubstrats 5 weg in die Tiefe verlagert. Die dadurch bedingte geringere Defektdichte in der Raumladungszone führt vorteilhaft zu verminderten Leckströmen und einem verbesserten Signal-zu-Rausch-Verhältnis (SNR).
Im Ergebnis wird mit der Erfindung eine Infrarot-Sensorvorrichtung mit hochsensitiven Bildpixeln, niedriger Wärmekapazität, geringer Wärmekopplung an das Substrat und damit hoher Bildwiederholfrequenz geschaffen. Gegenüber herkömmlichen Infrarot-Sensorvorrichtungen lässt sich die erfindungsgemäße Infrarot-Sensorvorrichtung bei gleichem Signal-zu-Rauschverhältnis kleiner und damit kostengünstiger herstellen.

## Patentansprüche

1. Infrarot-Sensorvorrichtung (100) mit:
einem SOI-Wafersubstrat (1), der ein Trägersubstrat (7), ein Oxidmaterial (6) und eine Bauelement-Schicht (5) aufweist;
einer Mehrzahl von in der Bauelement-Schicht (5) ausgebildeten Dioden als Sensorelement (2), wobei um das Sensorelement (2) herum und an der Unterseite des Sensorelements (2) das Oxidmaterial (3) angeordnet ist;
wobei das Sensorelement (2) durch Wärmeisolationsgräben (3) in Form eines umlaufenden Spalts (3) und durch eine Kaverne (8) im Trägersubstrat (8) vom restlichen SOI-Wafersubstrat (1) thermisch isoliert ist;
einer Aufhängeeinrichtung (10), mittels der das Sensorelement (2) im SOI-Wafersubstrat (1) aufgehängt ist;
wobei das Sensorelement (2) im Wesentlichen unterhalb der Aufhängeeinrichtung (10) angeordnet ist;
wobei die Dioden einkristalline, im Wesentlichen U-förmige Siliziumbereiche aufweisen;
wobei Dotierungsgebiete der Siliziumbereiche derart angeordnet sind, dass die Dioden im Wesentlichen vertikal ausgerichtet sind; und
wobei die Dotierungsgebiete durch das Oxidmaterial (6) voneinander und vom umgebenden Spalt (3) getrennt sind.

2. Infrarot-Sensorvorrichtung (100) nach Anspruch 1, **dadurch gekennzeichnet, dass** mittels der Aufhängeeinrichtung (10) das Sensorelement (2) in zwei Bereichen mit dem übrigen SOI-Wafersubstrat (1) verbunden ist, um eine elektrische Verbindung für das Sensorselement (2) bereitzustellen.

3. Infrarot-Sensorvorrichtung (100) nach einem der Ansprüche 1 oder 2, **dadurch gekennzeichnet, dass** die Aufhängeeinrichtung (10) in vertikaler Richtung symmetrisch ausgebildet ist, wobei eine elektrische Leiterbahn (4) in der Aufhängeeinrichtung (10) im Wesentlichen mittig zwischen zwei im Wesentlichen gleich dicken Schichten von Oxidmaterial (6) angeordnet ist und wobei die elektrische Leiterbahn (4) selbst schmaler als die Aufhängeeinrichtung (10) ist.

4. Infrarot-Sensorvorrichtung (100) nach Anspruch 3, **dadurch gekennzeichnet, dass** die Leiterbahn (4) im Wesentlichen im Zentrum des Sensorelements (2) ansetzt und oberhalb des Sensorelements (2) im Wesentlichen spiralförmig ausgebildet ist.

5. Infrarot-Sensorvorrichtung (100) nach Anspruch 3 oder 4, **dadurch gekennzeichnet, dass** ein Material der elektrischen Leiterbahn (4) wenigstens eines aus der Gruppe: Ti, TiN, Ta, TaN oder eine Kombination dieser Materialien ist.

6. Infrarot-Sensorvorrichtung (100) nach einem der vorhergehenden Ansprüche, **dadurch gekennzeichnet, dass** eine optische Dicke von auf dem Sensorelement (2) angeordneten Schichten des Oxidmaterials (6) im Wesentlichen einem ungeradzahligen Vielfachen eines Viertels einer zu detektierenden Wellenlänge entspricht.

7. Infrarot-Sensorvorrichtung (100) nach Anspruch 6, **dadurch gekennzeichnet, dass** eine Dicke der Schichten des Oxidmaterials (6) oberhalb des Sensorelements (2) größer ist als im Bereich der Aufhängeeinrichtung (10).

8. Infrarot-Sensorvorrichtung (100) nach einem der vorhergehenden Ansprüche, **dadurch gekennzeichnet, dass** auf einer Oberfläche des Sensorelements (2) eine Reflektorschicht (30) angeordnet ist.

9. Infrarot-Sensorfeld mit mehreren Infrarot-Sensorvorrichtungen (100) nach einem der Ansprüche 1 bis 8.

10. Infrarot-Sensorfeld nach Anspruch 9, **dadurch gekennzeichnet, dass** wenigstens Zeilen- oder Spaltenleitungen des Sensorfelds polykristallines Silizium (9) aufweisen.

11. Verfahren zur Herstellung einer Infrarot-Sensorvorrichtung (100) nach Anspruch 1, aufweisend die Schritte:
Bereitstellen des SOI-Wafersubstrats (1);
Ausbilden von den U-förmigen Siliziumbereichen in der Bauelement-Schicht (5), welche durch Gräben voneinander getrennt sind;
Verfüllen der Gräben mit dem Oxidmaterial (6);
Dotieren der Siliziumbereiche zum Ausbilden der Dioden des Sensorelements (2);
Erzeugen von Opferschichtätzlöchern auf Opferbereiche;
Opferschichtätzen der Opferbereiche zur Freistellung des Sensorelements (2), welches durch die Wärmeisolationsgräben (3) in Form des umlaufenden Spalts (3) und durch die Kaverne (8) im Trägersubstrat (8) vom restlichen SOI-Wafersubstrat (1) thermisch isoliert ist.

## Claims

1. Infrared sensor device (100) with:
an SOI wafer substrate (1), which comprises a carrier substrate (7), an oxide material (6) and a component layer (5);
a plurality of diodes formed in the component layer (5) as a sensor element (2), the oxide material (3) being arranged around the sensor element (2) and on the underside of the sensor element (2);
the sensor element (2) being thermally insulated from the rest of the SOI wafer substrate (1) by heat insulating trenches (3) in the form of a surrounding gap (3) and by a cavity (8) in the carrier substrate (8);
a suspension unit (10), by means of which the sensor element (2) is suspended in the SOI wafer substrate (1);
the sensor element (2) being arranged substantially below the suspension unit (10);
the diodes having monocrystalline, substantially U-shaped silicon regions;
doping zones of the silicon regions being arranged in such a way that the diodes are substantially vertically aligned; and
the doping zones being separated from one another and from the surrounding gap (3) by the oxide material (6).

2. Infrared sensor device (100) according to Claim 1, **characterized in that**, by means of the suspension unit (10), the sensor element (2) is connected in two regions to the rest of the SOI wafer substrate (1), in order to provide an electrical connection for the sensor element (2).

3. Infrared sensor device (100) according to either of Claims 1 and 2, **characterized in that** the suspension unit (10) is formed symmetrically in the vertical direction, an electrical conductor track (4) in the suspension unit (10) being arranged substantially in the middle between two layers of oxide material (6) of substantially the same thickness and the electrical conductor track (4) itself being narrower than the suspension unit (10) .

4. Infrared sensor device (100) according to Claim 3, **characterized in that** the conductor track (4) starts substantially in the centre of the sensor element (2) and is formed substantially spirally above the sensor element (2).

5. Infrared sensor device (100) according to Claim 3 or 4, **characterized in that** a material of the electrical conductor track (4) is at least one from the group: Ti, TiN, Ta, TaN or a combination of these materials

6. Infrared sensor device (100) according to one of the preceding claims, **characterized in that** an optical thickness of layers of the oxide material (6) arranged on the sensor element (2) corresponds substantially to an uneven multiple of one quarter of a wavelength to be detected.

7. Infrared sensor device (100) according to Claim 6, **characterized in that** a thickness of the layers of the oxide material (6) above the sensor element (2) is greater than in the region of the suspension unit (10).

8. Infrared sensor device (100) according to one of the preceding claims, **characterized in that** a reflector layer (30) is arranged on a surface of the sensor element (2).

9. Infrared sensor array with multiple infrared sensor devices (100) according to one of Claims 1 to 8.

10. Infrared sensor array according to Claim 9, **characterized in that** at least row or column lines of the sensor array comprise polycrystalline silicon (9).

11. Method for producing an infrared sensor device (100) according to Claim 1, comprising the steps of:
providing the SOI wafer substrate (1);
forming the U-shaped silicon regions in the component layer (5), which are separated from one another by trenches;
filling the trenches with the oxide material (6);
doping the silicon regions to form the diodes of the sensor element (2);
producing sacrificial layer etching holes on sacrificial regions;
sacrificial layer etching of the sacrificial regions to expose the sensor element (2), which is thermally insulated from the rest of the SOI wafer substrate (1) by the heat insulating trenches (3) in the form of the surrounding gap (3) and by the cavity (8) in the carrier substrate (8).

## Revendications

1. Dispositif capteur à infrarouges (100), comprenant :
un substrat de galette en SOI (1), lequel possède un substrat porteur (7), un matériau d'oxyde (6) et une couche de composant (5) ;
une pluralité de diodes formées dans la couche de composant (5) en tant qu'éléments capteurs (2), le matériau d'oxyde (3) étant disposé autour de l'élément capteur (2) et sur le côté inférieur de l'élément capteur (2) ;
l'élément capteur (2) étant isolé thermiquement du reste du substrat de galette en SOI (1) par des tranchées d'isolation thermique (3) sous la forme d'une fente circulaire (3) et par une cavité (8) dans le substrat porteur (8) ;
un dispositif de suspension (10) au moyen duquel l'élément capteur (2) est suspendu dans le substrat de galette en SOI (1) ;
l'élément capteur (2) étant sensiblement disposé au-dessous du dispositif de suspension (10) ;
les diodes possédant des zones de silicium monocristallin, sensiblement en forme de U ;
des régions de dopage des zones de silicium étant disposées de telle sorte que les diodes sont orientées sensiblement verticalement ; et
les régions de dopage étant séparées les unes des autres et de la fente périphérique (3) par le matériau d'oxyde (6).

2. Dispositif capteur à infrarouges (100) selon la revendication 1, **caractérisé en ce que** l'élément capteur (2) est relié au moyen du dispositif de suspension (10) dans deux zones avec le reste du substrat de galette en SOI (1) afin de fournir une liaison électrique pour l'élément capteur (2).

3. Dispositif capteur à infrarouges (100) selon l'une des revendications 1 ou 2, **caractérisé en ce que** le dispositif de suspension (10) est de configuration symétrique dans la direction verticale, une piste conductrice (4) électrique étant disposée dans le dispositif de suspension (10) sensiblement au centre entre deux couches de matériau d'oxyde (6) ayant sensiblement la même épaisseur, et la piste conductrice (4) électrique elle-même étant plus étroite que le dispositif de suspension (10).

4. Dispositif capteur à infrarouges (100) selon la revendication 3, **caractérisé en ce que** la piste conductrice (4) repose sensiblement au centre de l'élément capteur (2) et est de configuration sensiblement en forme de spirale au-dessus de l'élément capteur (2).

5. Dispositif capteur à infrarouges (100) selon la revendication 3 ou 4, **caractérisé en ce qu'**un matériau de la piste conductrice (4) électrique est au moins un matériau du groupe Ti, TiN, Ta, TaN ou une combinaison de ces matériaux.

6. Dispositif capteur à infrarouges (100) selon l'une des revendications précédentes, **caractérisé en ce qu'**une épaisseur optique des couches du matériau d'oxyde (6) disposées sur l'élément capteur (2) correspond sensiblement à un multiple impair d'un quart d'une longueur d'onde à détecter.

7. Dispositif capteur à infrarouges (100) selon la revendication 6, **caractérisé en ce qu'**une épaisseur des couches du matériau d'oxyde (6) au-dessus de l'élément capteur (2) est supérieure à celle dans la zone du dispositif de suspension (10).

8. Dispositif capteur à infrarouges (100) selon l'une des revendications précédentes, **caractérisé en ce qu'**une couche réfléchissante (30) est disposée sur une surface de l'élément capteur (2).

9. Matrice de détection à infrarouges comprenant plusieurs dispositifs capteurs à infrarouges (100) selon l'une des revendications 1 à 8.

10. Matrice de détection à infrarouges selon la revendication 9, **caractérisée en ce qu'**au moins des lignes de lignes ou de colonnes de la matrice de détection possèdent du silicium polycristallin (9).

11. Procédé de fabrication d'un dispositif capteur à infrarouges (100) selon la revendication 1, comprenant les étapes suivantes :
fourniture du substrat de galette en SOI (1) ;
formation de zones en silicium en forme de U dans la couche de composant (5), lesquelles sont séparées les unes des autres par des tranchées ;
remplissage des tranchées avec le matériau d'oxyde (6) ;
dopage des zones en silicium afin de former les diodes de l'élément capteur (2) ;
génération de trous gravés de couche sacrificielle sur des zones sacrificielles ;
gravure de couche sacrificielle des zones sacrificielles en vue de libérer l'élément capteur (2), lequel est isolé thermiquement du reste du substrat de galette en SOI (1) par les tranchées d'isolation thermique (3) sous la forme de la fente circulaire (3) et par la cavité (8) dans le substrat porteur (8).
